# EUROPÄISCHE PATENTSCHRIFT

(11) **EP 2 957 157 B1**
(45) Veröffentlichungstag und Bekanntmachung des Hinweises auf die Patenterteilung: **27.11.2019**
(21) Anmeldenummer: 14706467.9
(22) Anmeldetag: 03.02.2014
(51) Int. Cl.: H05K 7/20, H02G 3/04

(54) **KOMBINIERTER KABEL- UND LUFTKANAL FÜR DIE SCHALTSCHRANKKLIMATISIERUNG SOWIE EIN ENTSPRECHENDER SCHALTSCHRANK**
COMBINATION CABLE AND AIR CHANNEL FOR AIR CONDITIONING AN ELECTRICAL ENCLOSURE, AND A CORRESPONDING ELECTRICAL ENCLOSURE
CANAL DE CÂBLE ET D'AIR COMBINÉ POUR LA CLIMATISATION D'UNE ARMOIRE DE DISTRIBUTION ET ARMOIRE DE DISTRIBUTION CORRESPONDANTE

(30) Priorität: 15.02.2013 DE 102013101507
(43) Veröffentlichungstag der Anmeldung: 23.12.2015
(73) Patentinhaber: Rittal GmbH & Co. KG, 35745 Herborn (DE)
(72) Erfinder: WAGNER, Steffen, 57299 Burbach (DE); RONZHEIMER, Christine, 35232 Dautphetal-Herzhausen (DE); KNETSCH, Jörg, 35630 Ehringshausen (DE)
(74) Vertreter: Angerhausen, Christoph
(86) Internationale Anmeldenummer: PCT/DE2014/100027
(87) Internationale Veröffentlichungsnummer: WO 2014/124631

(56) Entgegenhaltungen:
- DE-B3-102011 015 547
- FR-A1- 2 691 227

## Beschreibung

Die Erfindung betrifft einen kombinierten Kabel- und Luftkanal für die Schaltschrankklimatisierung sowie einen entsprechenden Schaltschrank.

Die DE 10 2009 054 011 B4 beschreibt einen Schaltschrank mit einem Wandelement für die gezielte Kühlung von in dem Schaltschrank aufgenommenen, Wärme abgebenden Komponenten, wobei das Wandelement einen die Wärme abgebenden Komponenten aufnehmenden Schaltschrankinnenraum von einem Kaltluftraum abtrennt. In dem Kaltluftraum wird mit Hilfe eines Klimageräts gekühlte Luft zur Kühlung der Wärme abgebenden Komponenten bereitgestellt. Der Schaltschrankinnenraum und der Kaltluftraum stehen über eine Mehrzahl Durchlässe in dem Wandelement fluidisch in Verbindung, wobei gekühlte Luft aus dem Kaltluftraum durch die Durchlässe hindurch in den Schaltschrankinnenraum geführt ist. Einen ähnlichen Schaltschrank beschreibt auch die DE 197 28 306 A1.

Bei gattungsgemäßen Schaltschränken sind die sich aufgrund ihrer Verlustleistung aufheizenden und kühlbedürftigen Komponenten häufig auf einer Montageplatte mehr oder weniger in einer Ebene übereinander und nebeneinander angeordnet. Der aus der genannten Druckschrift bekannte Schaltschrank weist zur Kühlung der Komponenten in vertikaler Richtung voneinander beabstandet einen Warmluftauslass und einen Kaltlufteinlass auf. Über den Warmluftauslass, welcher bei Wandanbaugeräten häufig im oberen Bereich des Schaltschranks angeordnet ist, wird Warmluft aus dem Schaltschrankinnenraum abgeführt, durch einen Wärmetauscher eines Kühlgeräts hindurchgeführt, dort abgekühlt, und als Kaltluft durch den Kaltlufteinlass, welcher häufig im unteren Bereich des Schaltschrankes angeordnet ist, in den Schaltschrank eingeblasen.

Durch die relative Anordnung von Lufteinlass und Luftauslass zueinander ergibt sich im Schaltschrankinneren ein Temperaturgefälle von oben nach unten. Die eingeblasene Luft strömt in vertikaler Richtung von unten nach oben, so dass die tief gelegenen Komponenten mit der kühlsten Luft angeströmt werden, während darüber angeordnete Komponenten mit bereits durch die Abwärme der jeweils tiefer gelegenen Komponenten aufgewärmter Luft umströmt werden. Des Weiteren liegen höher gelegene Komponenten aufgrund der vertikalen Luftströmungsrichtung im Windschatten tiefer gelegener Komponenten, was die Kühlung der höher gelegenen Komponenten weiter verschlechtert. So kann es vorkommen, dass im oberen Bereich des Schaltschrankes Spitzentemperaturen erreicht werden, welche oberhalb einer oberen Grenztemperatur für die mittlere Schaltschranktemperatur liegen.

Die zuvor beschriebene Temperaturverteilung im Inneren des Schaltschrankes führt dazu, dass bei der Montage der Komponenten stärker temperaturempfindliche oder kühlbedürftige Komponenten im unteren Bereich des Schaltschrankes angeordnet werden müssen, während weniger temperaturempfindliche Komponenten auch im oberen Bereich des Schaltschrankes angeordnet werden können. Dies hat jedoch den Nachteil, dass zum einen der im Schaltschrank vorhandene Raum häufig nicht optimal, etwa unter Berücksichtigung des Formfaktors der Komponenten ausgenutzt werden kann, und dass andererseits zum Teil umfangreiche elektrische Verkabelungen zwischen zwar unmittelbar miteinander elektrisch verbundenen jedoch weit auseinander liegend angeordneten Komponenten bereitgestellt werden müssen. Darunter leidet nicht nur die Übersichtlichkeit des Komponentenaufbaus. Vielmehr behindert diese Verkabelung die ungehinderte Anströmung der Komponenten mit Kühlluft.

Die DE 10 2009 054 011 B4 schlägt zur Lösung dieser Probleme einen Schaltschrank vor, bei dem die zu kühlenden Komponenten an einer Trageinrichtung angeordnet sind, welche an ihrem unteren Ende einen Übergang zwischen dem Kaltluftgang und dem Schaltschrankinnenraum aufweist, über welchen ein Großteil der in dem Kaltluftgang bereitgestellten gekühlten Luft in den Schaltschrankinnenraum transportiert wird. Darüber hinaus wird ein Teil der in dem Kaltluftgang bereitgestellten, gekühlten Luft über Durchtrittsöffnungen in der Montageplatte in den Schaltschrankinnenraum geleitet, derart, dass bestimmte Komponenten entsprechend ihrer Verlustleistung gezielt angeströmt werden können. Dadurch wird auch erreicht, dass sich anstelle des zuvor beschriebenen Temperaturgradienten in vertikaler Richtung eine einheitlichere Temperatur im Schaltschrankinnenraum ausbildet.

Die aus der DE 10 2009 054 011 B4 bekannte Lösung ermöglicht es zwar, dass aufgrund der gezielten Anströmung kühlbedürftiger Komponenten ein höherer Freiheitsgrad bei der Anordnung der Komponenten auf der Montageplatte besteht und dadurch der Verkabelungsaufwand verringert wird. Andererseits bietet auch die bekannte Lehre kein zufriedenstellendes Kabelmanagement, welches es ermöglicht, dass die zu kühlenden Komponenten ungehindert angeströmt werden können.

CH 690 392 A5 offenbart einen kombinierten Kabel- und Luftkanal für die Schaltschrankklimatisierung gemäß dem Oberbegriff des Anspruchs 1. Es ist daher die Aufgabe der Erfindung, den gattungsgemäßen Schaltschrank derart weiter zu entwickeln, dass er neben der gezielten Anströmung kühlbedürftiger Komponenten im Schaltschrankinnenraum auch die möglichst verlustfreie Anströmung dieser ermöglicht, wobei letzteres insbesondere durch ein verbessertes Kabelmanagement erreicht werden sollte.

Diese Aufgabe wird erfindungsgemäß durch einen kombinierten Kabel- und Luftkanal für die Schaltschrankklimatisierung gemäß dem Patentanspruch 1 sowie durch einen entsprechenden Schaltschrank gemäß dem Patentanspruch 7 gelöst. Die abhängigen Ansprüche betreffen jeweils vorteilhafte Ausführungsformen der Erfindung.

Der erfindungsgemäße kombinierte Kabel- und Luftkanal für die Schaltschrankklimatisierung weist einen Luftkanal auf und einen an diesen angrenzenden, parallel zu dem Luftkanal geführten Kabelkanal, wobei eine erste Längsseite des Luftkanals mindestens einen Durchbruch aufweist, und wobei eine Längsseite des Kabelkanals eine abnehmbar verrastete Verschlussseite ist.

Ein entsprechender Schaltschrank weist einen erfindungsgemäßen kombinierten Kabel- und Luftkanal sowie eine Montageplatte auf, die einen Wärme abgebende Komponenten aufnehmenden Schaltschrankinnenraum von einem Kühlluftraum abtrennt, wobei der Schaltschrankinnenraum und der Kühlluftraum über mindestens einen Durchlass in der Montageplatte fluidisch in Verbindung stehen, und wobei gekühlte Luft aus dem Kühlluftraum durch den mindestens einen Durchlass und eine Lufteinlassöffnung des kombinierten Kabel- und Luftkanals hindurch in den kombinierten Kabel- und Luftkanal geführt ist.

Erfindungsgemäß kann der kombinierte Kabel- und Luftkanal schaltschrankinnenraumseitig über die zweite Längsseite des Luftkanals an der Montageplatte befestigt sein, so dass der Kabelkanal um eine Abmessung des Luftkanals parallel beabstandet von der Montageplatte angeordnet ist. Dabei kann der mindestens eine Durchbruch einen Luftdurchlass in Richtung parallel zu der Montageplatte bilden.

Alternativ können die Positionen von Kabel- und Luftkanal gegenüber der zuletzt beschriebenen Variante aber auch vertauscht sein, so dass der kombinierte Kabel- und Luftkanal schaltschrankinnenraumseitig über eine Längsseite des Kabelkanals an der Montageplatte befestigt ist, so dass der Luftkanal um eine Abmessung des Kabelkanals parallel beabstandet von der Montageplatte angeordnet ist. Diese Variante kommt insbesondere bei elektrischen Komponenten in Betracht, bei denen der Ansaugbereich für die Kaltluft vor dem elektrischen Anschlussbereich und damit beabstandet von der Montageplatte angeordnet ist.

Trennt die Montageplatte einen Schaltschrankinnenraum von einem Kühlluftraum, ist eine Ausführungsform der Erfindung denkbar, bei welcher die zweite Längsseite des Luftkanals, über welche der kombinierte Kabel- und Luftkanal auf der Montageplatte aufgesetzt ist, eine Lufteinlassöffnung für Kühlluft aufweist, so dass der Montageaufwand für die Zuführung der Kühlluft in den Luftkanal minimiert ist. Es sind jedoch auch andere Arten der Luftzuführung in den Luftkanal denkbar. Bei einer anderen Ausführungsform weist der Luftkanal beispielsweise an seiner Stirnseite eine Lufteinlassöffnung für Kühlluft auf.

Bei einer Ausführungsform der Erfindung weist die Längsseite des Luftkanals eine Mehrzahl mit Sollbruchstellen versehene, wahlweise aufbrechbare Durchbrüche auf. Bei dieser Ausführungsform ist es somit vorgesehen, ein weitestgehend standardisiertes Bauteil bereitzustellen, mit einer Anordnung vorgegebener, wahlweise öffenbarer Durchbrüche, so dass ein Benutzer je nach Anwendungsfall nach eigenem Belieben beispielsweise diejenigen Durchbrüche durch Eindrücken dieser entlang der Sollbruchstellen öffnen kann, welche nahe der zu kühlenden Komponente angeordnet sind. Darüber hinaus kann durch die Zahl der geöffneten Durchbrüche der der zu kühlenden Komponenten zugeleitete Kühlluftvolumenstrom angepasst werden.

Erfindungsgemäß weist der Luftkanal einen rechteckigen Querschnitt und eine zweite Längsseite auf, über welche der kombinierte Kabel- und Luftkanal an einer Montageseite oder an einer Schaltschrankwand montierbar ist, wobei sich die zweite Längsseite senkrecht zu der ersten Längsseite des Luftkanals erstreckt.

Bei einer Ausführungsform erstreckt sich die Verschlussseite des Kabelkanals parallel beabstandet zu der zweiten Längsseite des Luftkanals. Besonders bevorzugt bilden dabei die Verschlussseite und die zweite Längsseite gegenüberliegende Außenseiten des kombinierten Kabel- und Luftkanals. Ist somit der kombinierte Kabel- und Luftkanal über die zweite Längsseite des Luftkanals an einer Montageplatte befestigt, ist der Kabelkanal über die Verschlussseite besonders einfach zugänglich, da diese dem Monteur zugewandt ist.

Erfindungsgemäß ist der kombinierte Kabel- und Luftkanal einstückig ausgebildet. Dabei kann vorgesehen sein, dass der Luftkanal und der Kabelkanal über ein sich parallel beabstandet zu der Verschlussseite und zu der zweiten Längsseite des Luftkanals erstreckendes Wandelement voneinander abgetrennt sind.

Bei einer Ausführungsform der Erfindung sind die Durchbrüche rechteckig. Die Sollbruchstellen können U-förmig ausgebildet sein. Dabei können die Durchbrüche weiterhin ein Filmscharnier aufweisen, so dass beim Eindrücken der Durchbrüche entlang der Sollbruchstellen der eingedrückte Teil des Durchbruchs nicht in den Luftkanal hineinfällt, sondern sich entlang des Filmscharniers in den Luftkanal einschwenken lässt.

Weitere Einzelheiten der Erfindung werden anhand der nachstehenden Figuren erläutert. Dabei zeigt:
- Figur 1: Eine perspektivische Ansicht eines Endabschnitts einer Ausführungsform des erfindungsgemäßen kombinierten Kabel- und Luftkanals; und
- Figur 2: eine perspektivische Ansicht auf die geöffnete Seitenwand eines Schaltschranks, welcher einen kombinierten Kabel- und Luftkanal gemäß Figur 1 aufweist.

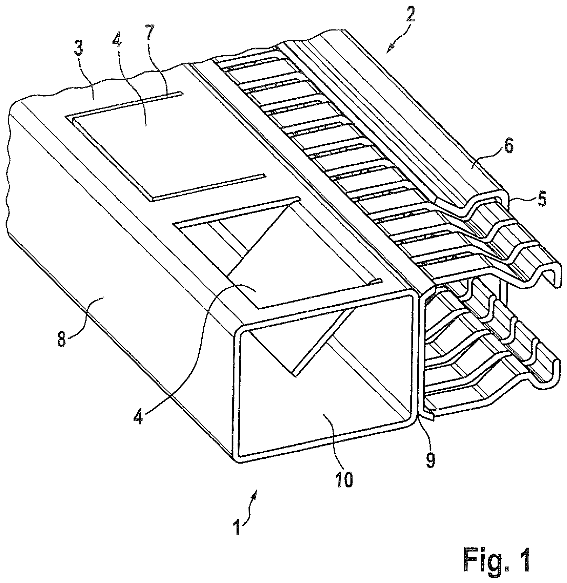

Der in Figur 1 gezeigte kombinierte Kabel- und Luftkanal weist einen Luftkanal 1 und einen an den Luftkanal 1 angrenzenden, parallel zu diesem geführten Kabelkanal 2 auf. An einer ersten Längsseite 3 des Luftkanals 1 sind mehrere Durchbrüche 4 ausgebildet, welche Sollbruchstellen 7 aufweisen. Die Sollbruchstellen 7 sind derart beschaffen, dass sie einerseits druckdicht sind, andererseits jedoch die Durchbrüche 4 mit den Fingern oder dem Daumen eingedrückt werden können, wo immer Kühlluft einer bestimmten Komponente zugeführt werden soll. Zur besseren Veranschaulichung der erfindungsgemäßen Lehre ist in Figur 1 der Durchbruch 4 oben links mit seiner Sollbruchstelle 7 im geschlossenen Zustand gezeigt, während der Durchbruch 4 unten rechts bereits eingedrückt worden ist. Die Sollbruchstellen 7 sind erkennbar U-förmig ausgebildet, wobei die freien Enden der Sollbruchstellen 7 über ein Filmscharnier miteinander verbunden sind, so dass beim Eindrücken der Durchbrüche 4 der eingedrückte Teil des Durchbruchs 4 nicht in den Luftkanal 1 hineinfällt.

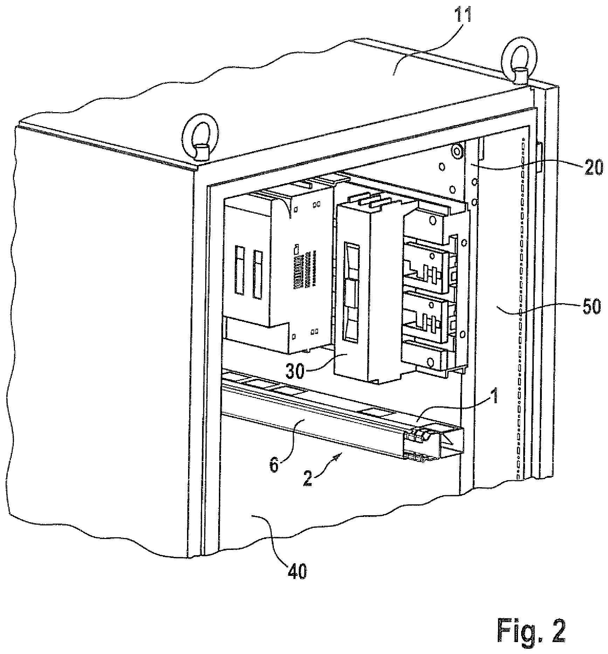

Die Verschlussseite 6 ist an dem Kabelkanal 2 verrastet und somit für die Bestückung des Kabelkanals 2 wahlweise abnehmbar und wieder aufrastbar. Die Verschlussseite 6 erstreckt sich parallel zu der zweiten Längsseite 8 des Luftkanals 1, wobei die Längsseite 8 und die Verschlussseite 6 gerade gegenüberliegende Außenseiten des kombinierten Kabel- und Luftkanals bilden. Liegt der kombinierte Kabel- und Luftkanal über die zweite Längsseite 8 auf einer Montageplatte 20 auf (siehe Figur 2), ist die Verschlussseite 6 gerade dem Monteur zugewandt, so dass dieser einfach auf den Kabelkanal 2 zugreifen kann.

Die erste Längsseite 3 und die zweite Längsseite 8 bilden gerade rechtwinklig aufeinander stehende Außenseiten des im Querschnitt rechteckigen Luftkanals 1. Ist der kombinierte Kabel- und Luftkanal, wie in Figur 2 gezeigt ist, horizontal über die zweite Längsseite 8 auf eine Montageplatte 20 aufgesetzt, erstreckt sich auch die erste Längsseite 3 horizontal, so dass über die Durchbrüche 4 austretende Luft in vertikaler Richtung ausgeströmt wird und somit eine optimale Anströmung der über oder unter dem kombinierten Kabel- und Luftkanal angeordneten, ebenso auf der Montageplatte befestigten Komponenten erreicht wird.

Der Kabelkanal weist an gegenüberliegenden Längsseiten Beinelemente auf, welche an ihrem freien Ende jeweils einen Hinterschnitt aufweisen. Die Verschlussseite 6 weist an gegenüberliegenden Innenseiten jeweils einen Vorsprung auf, über welche die Verschlussseite 6 auf den freien Enden der Beinelemente verrastbar ist.

Die in den Figuren 1 und 2 gezeigte Ausführungsform weist einen Luftkanal 1 auf, welcher an seiner Stirnseite eine Lufteinlassöffnung 10 für Kühlluft aufweist. Diese Lufteinlassöffnung 10 kann mit einer Kühlluftzuführleitung eines Klimageräts in Verbindung gebracht werden. Die Kühlluftzuführleitung kann neben der Montageplatte 20 geführt sein und behindert somit nicht die über die Durchbrüche 4 ausströmende Kühlluft.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

### Bezugszeichenliste

- 1: Luftkanal
- 2: Kabelkanal
- 3: erste Längsseite des Luftkanals
- 4: Durchbruch
- 5: Längsseite des Kabelkanals
- 6: Verschlussseite
- 7: Sollbruchstelle
- 8: zweite Längsseite des Luftkanals
- 9: Wandelement
- 10: Lufteinlassöffnung
- 11: Schaltschrank
- 20: Montageplatte
- 30: Wärme abgebende Komponente
- 40: Schaltschrankinnenraum
- 50: Kühlluftraum

## Patentansprüche

1. Kombinierter Kabel- und Luftkanal für die Schaltschrankklimatisierung, mit einem Luftkanal (1) und einem an den Luftkanal (1) angrenzenden, parallel zu dem Luftkanal (1) geführten Kabelkanal (2), wobei eine erste Längsseite (3) des Luftkanals (1) mindestens einen Durchbruch (4) aufweist, und wobei eine Längsseite (5) des Kabelkanals (2) eine abnehmbar verrastete Verschlussseite (6) ist, wobei der Luftkanal (1) einen rechteckigen Querschnitt und eine zweite Längsseite (8) aufweist, über welche der kombinierte Kabel- und Luftkanal an einer Montageplatte (20) oder an einer Schaltschrankwand montierbar ist, wobei sich die zweite Längsseite (8) senkrecht zu der ersten Längsseite (3) des Luftkanals (1) erstreckt, **dadurch gekennzeichnet, dass** der Luftkanal (1) und der Kabelkanal (2) über ein sich parallel beabstandet zu der Verschlussseite (6) und zu der zweiten Längsseite (8) des Luftkanals (1) erstreckendes Wandelement (9) voneinander abgetrennt sind.

2. Kombinierter Kabel- und Luftkanal nach Anspruch 1, bei dem die Längsseite (3) des Luftkanals (1) eine Mehrzahl mit Sollbruchstellen (7) versehene, wahlweise aufbrechbare Durchbrüche (4) aufweist.

3. Kombinierter Kabel- und Luftkanal nach Anspruch 1, bei dem sich die Verschlussseite (6) des Kabelkanals (2) parallel beabstandet zu der zweiten Längsseite (8) des Luftkanals (1) erstreckt.

4. Kombinierter Kabel- und Luftkanal nach einem der vorangegangenen Ansprüche, bei dem der mindestens eine Durchbruch (4) rechteckig ist und U-förmig angeordnete Sollbruchstellen (7) aufweist.

5. Kombinierter Kabel- und Luftkanal nach Anspruch 1, bei dem die zweite Längsseite (8) des Luftkanals (1) eine Lufteinlassöffnung (10) für Kühlluft aufweist.

6. Kombinierter Kabel- und Luftkanal nach einem der vorangegangenen Ansprüche, bei dem der Luftkanal (1) an einer Stirnseite eine Lufteinlassöffnung (10) für Kühlluft aufweist.

7. Schaltschrank (11) mit einem kombinierten Kabel- und Luftkanal nach einem der vorangegangenen Ansprüche sowie mit einer Montageplatte (20), die einen Wärme abgebende Komponenten (30) aufnehmenden Schaltschrankinnenraum (40) von einem Kühlluftraum (50) abtrennt, wobei der Schaltschrankinnenraum (40) und der Kühlluftraum (50) über mindestens einen Durchlass in der Montageplatte (20) fluidisch in Verbindung stehen, und wobei gekühlte Luft aus dem Kühlluftraum (50) durch den mindestens einen Durchlass und eine Lufteinlassöffnung (10) des kombinierten Kabel- und Luftkanals hindurch in den kombinierten Kabel- und Luftkanal geführt ist.

8. Schaltschrank nach Anspruch 7, bei dem der kombinierten Kabel- und Luftkanal schaltschrankinnenraumseitig über die zweite Längsseite (8) des Luftkanals (1) an der Montageplatte (20) befestigt ist, so dass der Kabelkanal (2) um eine Abmessung des Luftkanals (1) parallel beabstandet von der Montageplatte (20) angeordnet ist, und wobei der mindestens eine Durchbruch (4) einen Luftdurchlass in Richtung parallel zu der Montageplatte (20) bildet.

## Claims

1. A combined cable and air channel for air conditioning a switch cabinet, with an air channel (1) and a cable channel (2) which adjoins the air channel (1) and which is led parallel to the air channel (1), wherein a first longitudinal face (3) of the air channel (1) has at least one opening (4), and wherein one longitudinal face (5) of the cable channel (2) is a closure face (6) which is locked in a removable manner, wherein the air channel (1) has a rectangular cross section and a second longitudinal face (8), by which the combined cable and air channel can be mounted on a mounting plate (20) or on a wall of a switch cabinet, wherein the second longitudinal face (8) extends perpendicular to the first longitudinal face (3) of the air channel (1), **characterized in that** the air channel (1) and the cable channel (2) are separated from each other by a wall element (9) extending parallel to and spaced apart from the closure face (6) and the second longitudinal face (8) of the air channel (1).

2. The combined cable and air channel according to claim 1, in which the longitudinal face (3) of the air channel (1) has multiple optionally breakable openings (4) with predetermined breaking points (7).

3. The combined cable and air channel according to claim 1, in which the closure face (6) of the cable channel (2) extends parallelly spaced apart from the second longitudinal face (8) of the air channel (1).

4. The combined cable and air channel according to any of the preceding claims, in which the at least one opening (4) is rectangular and has predetermined breaking points (7) arranged in a U-shape.

5. The combined cable and air channel according to claim 1, wherein the second longitudinal face (8) of the air channel (1) has an air inlet opening (10) for cooling air.

6. The combined cable and air channel according to any of the preceding claims, in which the air channel (1) has an air inlet opening (10) for cooling air at a face side.

7. Switch cabinet (11) having a combined cable and air channel according to any of the preceding claims and a mounting plate (20), which separates an interior space (40) of the switch cabinet accommodating heat-producing components (30) from a cooling air space (50), wherein the interior space (40) of the switch cabinet and the cooling air space (50) are in fluidic connection across at least one passageway in the mounting plate (20), and wherein cooled air from the cooling air space (50) is led through the at least one passageway and an air inlet opening (10) of the combined cable and air channel into the combined cable and air channel.

8. The switch cabinet according to claim 7, in which the combinaed cable and air channel is fastened to the mounting plate (20) by the second longitudinal face (8) of the air channel (1) on the side of the interior space of the switch cabinet, so that the cable channel (2) is arranged parallelly spaced apart from the mounting plate (20) by a dimension of the air channel (1), and wherein the at least one opening (4) forms an air passage in a direction parallel to the mounting plate (20).

## Revendications

1. Canal de câble et d'air combiné pour la climatisation d'une armoire de distribution, avec un canal d'air (1) et un canal de câble (2) adjacent au canal d'air (1), guidé parallèlement au canal d'air (1), dans lequel un premier côté longitudinal (3) du canal d'air (1) comporte au moins un passage (4), et dans lequel un côté longitudinal (5) du canal de câble (2) est un côté de fermeture (6) encliqueté de façon amovible, dans lequel le canal d'air (1) comporte une section transversale rectangulaire et un deuxième côté longitudinal (8) par le biais duquel le canal de câble et d'air combiné peut être monté sur une plaque de montage (20) ou sur une paroi de l'armoire de distribution, dans lequel le deuxième côté longitudinal (8) s'étend perpendiculairement au premier côté longitudinal (3) du canal d'air (1), **caractérisé en ce que** le canal d'air (1) et le canal de câble (2) sont séparés l'un de l'autre par le biais d'un élément de paroi (9) s'étendant parallèlement à distance du côté de fermeture (6) et du deuxième côté longitudinal (8) du canal d'air (1).

2. Canal de câble et d'air combiné selon la revendication 1, dans lequel le côté longitudinal (3) du canal d'air (1) comporte une pluralité de passages (4) munis d'emplacements destinés à la rupture (7), au choix pouvant être forcés.

3. Canal de câble et d'air combiné selon la revendication 1, dans lequel le côté de fermeture (6) du canal de câble (2) s'étend parallèlement à distance du deuxième côté longitudinal (8) du canal d'air (1).

4. Canal de câble et d'air combiné selon l'une des revendications précédentes, dans lequel l'au moins un passage (4) est rectangulaire et comporte des emplacements destinés à la rupture (7) disposés en forme de U.

5. Canal de câble et d'air combiné selon la revendication 1, dans lequel le deuxième côté longitudinal (8) du canal d'air (1) comporte une ouverture d'admission d'air (10) pour de l'air de refroidissement.

6. Canal de câble et d'air combiné selon l'une des revendications précédentes, dans lequel le canal d'air (1) comporte sur son côté frontal une ouverture d'admission d'air (10) pour de l'air de refroidissement.

7. Armoire de distribution (11) avec un canal de câble et d'air combiné selon l'une des revendications précédentes ainsi qu'avec une plaque de montage (20) qui réalise une séparation entre un espace intérieur de l'armoire de distribution (40) logeant des composants (30) émettant de la chaleur et un espace d'air de refroidissement (50), dans laquelle l'espace intérieur de l'armoire de distribution (40) et l'espace d'air de refroidissement (50) sont en liaison fluidique par le biais d'au moins un passage dans la plaque de montage (20), et dans laquelle de l'air refroidi est conduit dans le canal de câble et d'air combiné à partir de l'espace d'air de refroidissement (50) et à travers l'au moins un passage et une ouverture d'admission d'air (10) du canal de câble et d'air combiné.

8. Armoire de distribution selon la revendication 7, dans laquelle, côté espace intérieur de l'armoire de distribution, le canal de câble et d'air combiné est fixé sur la plaque de montage (20) par le biais du deuxième côté longitudinal (8) du canal d'air (1) de telle sorte que le canal de câble (2) est disposé parallèlement à une distance de la plaque de montage (20) correspondant à une dimension du canal d'air (1), et dans lequel l'au moins un passage (4) forme un passage d'air dans une direction parallèle à la plaque de montage (20).
